# EUROPEAN PATENT SPECIFICATION

(11) **EP 1 401 027 B1**
(45) Date of publication and mention of the grant of the patent: **08.04.2009**
(21) Application number: 03078515.8
(22) Date of filing: 23.05.2002
(51) Int. Cl.: H01L 33/00

(54) **Group III nitride based light emitting diode with a superlattice structure**
Leuchtdiodenstruktur auf Basis einer Nitridverbindung der Gruppe III mit Übergitter
Structure de diode électroluminescente à base de nitrure de groupe III avec un super réseau

(30) Priority: 30.05.2001 US 294445 P; 30.05.2001 US 294308; 30.05.2001 US 294378 P; 07.05.2002 US 140796
(43) Date of publication of application: 24.03.2004
(62) Divisional of application: 02726917.4
(73) Proprietor: CREE, INC., Charlotte, NC 27703 (US)
(72) Inventor: Emerson, David Todd, Durham, North Carolina 27707 (US); Bergmann, Michael John, Chapel Hill,North Carolina 27516 (US); Doverspike, Kathleen Marie, Durham, North Carolina 27502 (US); O'Loughlin, Michael John, Chapel Hill, North Carolina 27516 (US); Nordby, Howard Dean Jr., Pittsboro, North Carolina 27312 (US); Abare, Amber Christine, Cary, North Carolina 27511 (US); Ibbetson, James, Santa Barbara, California 93111 (US)
(74) Representative: Bankes, Stephen Charles Digby

(56) References cited:
- EP-A- 1 063 711
- WO-A-00/76004
- WO-A-02/05399
- US-A- 6 153 894
- PATENT ABSTRACTS OF JAPAN vol. 1999, no. 05, 31 May 1999 (1999-05-31) & JP 11 040850 A (TOYODA GOSEI CO), 12 February 1999 (1999-02-12)

## Description

This invention relates to microelectronic semiconductor devices and more particularly to Group III nitride-based light emitting diodes (LEDs),

Light emitting diodes are widely used in consumer and commercial applications. As is well known to those having skill in the art, a light emitting diode generally includes a diode region on a microelectronic substrate. The microelectronic substrate may comprise, for example, gallium arsenide, gallium phosphide, alloys thereof, silicon carbide and/or sapphire. Continued developments in LEDs have resulted in highly efficient and mechanically robust light sources that can cover the visible spectrum and beyond. These attributes, coupled with the potentially long service life of solid state devices, may enable a variety of new display applications, and may place LEDs in a position to compete with the well entrenched incandescent lamp.

One difficulty in fabricating Group III nitride based LEDs, such as gallium nitride based LEDs, has been with the fabrication of high quality gallium nitride. Typically, gallium nitride LEDs have been fabricated on sapphire or silicon carbide substrates. Such substrates may result in mismatches between the crystal lattice of the substrate and the gallium nitride. Various techniques have been employed to overcome potential problems with the growth of gallium nitride on sapphire and/or silicon carbide. For example, aluminum nitride (A1N) may be utilized as a buffer between a silicon carbide substrate and a Group III active layer, particularly a gallium nitride active layer. Typically, however, aluminum nitride is insulating rather than conductive. Thus, structures with aluminum nitride buffer layers typically require shorting contacts that bypass the aluminum nitride buffer to electrically link the conductive silicon carbide substrate to the Group III nitride active layer.

Alternatively, conductive buffer layer materials such as gallium nitride (GaN), aluminum gallium nitride (AlGaN), or combinations of gallium nitride and aluminum gallium nitride may allow for elimination of the shorting contacts typically utilized with A1N buffer layers. Typically, eliminating the shorting contact reduces the epitaxial layer thickness, decreases the number of fabrication steps required to produce devices, reduces the overall chip size, and/or increases the device efficiency. Accordingly, Group III nitride devices may be produced at lower cost with a higher performance. Nevertheless, although these conductive buffer materials offer these advantages, their crystal lattice match with silicon carbide is less satisfactory than is that of aluminum nitride.

The above described difficulties in providing high quality gallium nitride may result in reduced efficiency the device. Attempts to improve the output of Group III nitride based devices have included differing configurations of the active regions of the devices. Such attempts have, for example, included the use of single and/or double heterostructure active regions. Similarly, quantum well devices with one or more Group III nitride quantum wells have also been described. While such attempts have improved the efficiency of Group III based devices, further improvements may still be achieved.

EP 1063711 discloses a Group III nitride based LED comprising a substrate, four GaN layers, a GaN/InGaN superlattice structure an InGaN based light emitting region, a GaN/InGaN multilayer structure, and a GaN layer.

WO0076004 discloses a Group III nitride based LED comprising a substrate, an AlGaN layer, two GaN layers, a GaN multilayer structure, a GaN/InGaN superlattice structure, an InGaN based light emitting region, an AlGaN layer, and a GaN layer.

The present invention provides a Group III nitride based semiconductor device according to claim 1.

Embodiments of the present invention include a light emitting diode having a Group III nitride based superlattice and a Group III nitride based active region on the superlattice. The active region preferably has at least one quantum well structure, which may include a first Group III nitride based barrier layer, a Group III nitride based quantum well layer on the first barrier layer and a second Group III nitride based barrier layer on the quantum well layer. The light emitting diode may includes from 2 to 10 repetitions of the quantum well structure.

The first Group III nitride based barrier layer provides a well support layer comprising a Group III nitride and the second Group III nitride based barrier layer provides a cap layer comprising a Group III nitride on the quantum well layer.

In such embodiments, the cap layer may have a lower crystal quality than the well support layer.

In still further embodiments of the present invention, the well support layer comprises a gallium nitride based layer, the quantum well layer comprises an indium gallium nitride layer and the barrier layer comprises a gallium nitride based layer. In such embodiments, the well support layer and the cap layer may be provided by layers of InχGa₁₋xN where 0≤X<1. Furthermore, the indium composition of the well support layer and the cap layer may be less than the indium composition of the quantum well layer.

The well support layer and the cap layer may also be provided by a layer of AlₓInₓGa_{1-x-y}N where 0<X<1, 0≤Y<1 and X+Y≤1. Furthermore, the well support layer and the cap layer may be undoped. Alternatively, the well support layer and the cap layer may have an n-type doping level of less than 5x10¹⁹ cm⁻³. The cap layer and the well support layer may also have a higher bandgap than the quantum well layer. The combined thickness of the well support layer and the cap layer may be from 5 nm to 40 nm. The thickness of the well support layer may be greater than a thickness of the cap layer. The quantum well layer may have a thickness of from 1 nm to 5 nm. For example, the quantum well layer may have a thickness of about 2 nm. Furthermore, the percentage of indium in the quantum well layer may be from 15% to 40%.

In additional embodiments of the present invention, a Group III nitride based spacer layer is provided between the well support layer and the superlattice. The spacer layer may be undoped GaN.

In other embodiments of the present invention, the bandgap of the quantum well is less than the bandgap of the superlattice.

In further embodiments of the present invention, the light emitting diode includes a second well support layer comprising a Group III nitride on the cap layer, a second quantum well layer comprising a Group III nitride on the second well support layer and a second cap layer comprising a Group III nitride on the second quantum well layer.

In additional embodiments of the present invention, the gallium nitride based superlattice comprises from 5 to 50 periods. The alternating layers of GaN and In_{Y}Ga_{1-Y}N may have a combined thickness of from 1 nm to 14 nm.

The gallium nitride based superlattice is doped with silicon to a level of from 1x10¹⁷ cm⁻³ to 5x10¹⁹cm⁻³. The doping level of the gallium nitride based superlattice may be an actual doping level of layers of the alternating layers. The doping level may also be an average doping level of layers of the alternating layers. Thus, for example, the light emitting diode may include doped Group III nitride layers adjacent the superlattice where the doped Group III nitride layers are doped with siliconto provide an average doping of the doped Group III nitride layers and the superlattice of from 1x10¹⁷ cm⁻³ to 5x10¹⁹ cm⁻³. The bandgap of the superlattice may be from 2.95 eV to 3.35 eV and, in certain embodiments, may be about 3.15 eV.

In other embodiments of the present invention, a Group III nitride based semiconductor device having an active region comprising at least one quantum well structure is provided. The quantum well structure includes a well support layer comprising a Group III nitride, a quantum well layer comprising a Group III nitride on the well support layer and a cap layer comprising a Group III nitride on the quantum well layer.

The cap layer may have a lower crystal quality than the well support layer. The well support layer may be provided by a gallium nitride based layer, the quantum well layer may be provided by an indium gallium nitride layer and the barrier layer may be provided by a gallium nitride based layer. In such embodiments, the well support layer and the cap layer may be provided by layers of In_{X}Ga_{1-X}N where 0≤X<1. Furthermore, the indium composition of the well support layer and the cap layer may be less the indium composition of the quantum well layer. Similarly, the well support layer and the cap layer may be provided by layers of Al_{X}In_{Y}Ga_{1-X-Y}N where 0<X<1, 0≤Y<1 and X+Y≤1.

Furthermore, the well support layer and the cap layer may be undoped. Alternatively, the well support layer and the cap layer may have a doping level of less than 5x10¹⁹ cm⁻³.

In further embodiments of the present invention, the cap layer and the well support layer have a higher bandgap than the quantum well layer. The combined thickness of the well support layer and the cap layer may be from 5 nm 0 to 40 nm. For example, the combined thickness of the well support layer and the cap layer may be greater than 9 nm. Similarly, the combined thickness of the well support layer and the cap layer may be 225 nm. The thickness of the well support layer may be greater than the thickness of the cap layer.

In additional embodiments of the present invention, the quantum well layer has a thickness of from 1 nm to 5 nm. For example, the quantum well layer may have a thickness of 25 nm. Furthermore, the percentage of indium in the quantum well layer may from 5% to 50%.

In further embodiments of the Group III nitride based semiconductor device according to the present invention, a superlattice is provided and the well support layer is on the superlattice. The superlattice may have a bandgap of 3.15 eV. Furthermore, a Group III nitride based spacer layer may be provided between the well support layer and the superlattice. The spacer layer may be undoped GaN. Also, the bandgap of the at least one quantum well may be less than the bandgap of the superlattice.

In still further embodiments of the present invention, a second well support layer comprising a Group III nitride is provided on the cap layer. A second quantum well layer comprising a Group III nitride is provided on the second well support layer; and a second cap layer comprising a Group III nitride is provided on the second quantum well layer.

In particular embodiments ofthe present invention, the Group III nitride based semiconductor device includes from 2 to 10 repetitions of the quantum well structures.

Embodiments of the present invention further provide a Group III nitride based semiconductor device that includes a gallium nitride based superlattice having at least two periods of alternating layers of GaN and In_{Y}Ga_{1-Y}N, 0 < Y < 1.

In further embodiments of the present invention, the gallium nitride based superlattice includes from 5 to 50 periods. For example, the gallium nitride based superlattice may include 25 periods. Similarly, the gallium nitride based superlattice may include 10 periods.

In additional embodiments of the present invention, the gallium nitride based superlattice comprises from 5 to 50 periods. The alternating layers of GaN and In_{Y}Ga_{1-Y}N may have a combined thickness of from about 1 nm to about 14 nm.

The InGaN layers may have a thickness of from 0,5 nm to 4 nm and the GaN layers may have a thickness of from 0,5 nm to 10 nm. According to the present invention, the gallium nitride based superlattice is doped with silicon to a level of from 1x10¹⁷ cm⁻³ to 5x10¹⁹cm⁻³. The doping level of the gallium nitride based superlattice may be an actual doping level of layers of the alternating layers or may be an average doping level of layers of the alternating layers.

In certain embodiments of the present invention, doped Group III nitride layers are provided adjacent the superlattice. The doped Group III nitride layers are doped with an n-type impurity to provide an average doping of the doped Group III nitride layers and the superlattice of from 1x10¹⁷ cm⁻³ to 5x10¹⁹cm⁻³.

In additional embodiments ot the present invention, a bandgap of the superlattice is 3.15 eV.

The light emitting diode includes a Group III nitride based active region on the superlattice. Additionally, a Group III nitride based spacer layer may also be provided between the active region and the superlattice. Such a spacer layer may be undoped GaN.

In certain embodiments of the present invention, the active region comprises at least one quantum well. In such embodiments, a bandgap of the quantum well may be less than a bandgap of the superlattice.

Additional embodiments not forming part of the present invention provide a method of fabricating a Group III nitride based semiconductor device having an active region comprising at least one quantum well structure. The quantum well structure is fabricated by forming a well support layer comprising a Group III nitride, forming a quantum well layer comprising a Group III nitride on the quantum well support layer and forming a cap layer comprising a Group III nitride on the quantum well layer.

In particular embodiments not forming part of the present invention, forming a well support layer comprising a Group III nitride is provided by forming the well support layer at a first temperature. Forming a quantum well layer is provided by forming the quantum well layer at a second temperature which is less than the first temperature. Forming a cap layer is provided by forming the cap layer at a third temperature which is less than the first temperature. In certain embodiments not forming part of the present invention, the third temperature is substantially the same as the second temperature.

In further embodiments not forming part of the present invention, the well support layer comprises a gallium nitride based layer, the quantum well layer comprises an indium gallium nitride layer and the cap layer comprises a gallium nitride based layer. In such embodiments, the first temperature may be from 700 to 900 °C. Furthermore, the second temperature may be from 0 to 200 °C less than the first temperature. The indium gallium nitride layer may be formed in a nitrogen atmosphere or other atmosphere.

Preferably, forming a well support layer and forming a cap layer are provided by forming a cap layer of In_{X}Ga_{1-X}N, where 0≤X<1 and forming a well support layer of In_{X}Ga_{1-X}N, where 0≤X<1. Also, the indium composition of the well support layer and the cap layer may be less an indium composition of the quantum well layer.

In additional embodiments of the present invention, forming a well support layer and forming a cap layer are provided by forming a cap layer of Al_{X}In_{Y}Ga_{1-X-Y}N, where 0<X<1, 0≤Y<1 and X+Y≤1 and forming a well support layer of Al_{X}In_{Y}Ga_{1-X-Y}N, where 0<X<1, 0≤Y<1 and X+Y≤1.

Further embodiments of the present invention include forming a superlattice, where the well support layer is on the superlattice. Additional embodiments of the present invention include, forming a Group III nitride based spacer layer between the well support layer and the superlattice. The spacer layer may be undoped GaN. Additional embodiments of the present invention include forming a second well support layer comprising a Group III nitride on the cap layer, forming a second quantum well layer comprising a Group III nitride on the second well support layer and forming a second cap layer comprising a Group III nitride on the second quantum well layer. In such embodiments not forming part of the present invention, the second well support layer may be formed at substantially the first temperature, the second quantum well layer may be formed at substantially the second temperature which is less than the first temperature and the second cap layer formed at substantially the third temperature which is less than the first temperature.

### Brief Description of the Drawings

Other features of the present invention will be more readily understood from the following detailed description of specific embodiments thereof when read in conjunction with the accompanying drawings, in which:
**Figure 1** is a schematic illustration of a Group III nitride light emitting diode incorporating embodiments of the present invention;
**Figure 2** is a schematic illustration of a Group III nitride light emitting diode incorporating further embodiments of the present invention; and
**Figure 3** is a schematic illustration of a quantum well structure and a multi-quantum well structure according to additional embodiments of the present invention.

### Detailed Description of Preferred Embodiments

The present invention now will be described more fully hereinafter with reference to the accompanying drawings, in which preferred embodiments of the invention are shown. This invention may, however, be embodied in many different forms and should not be construed as limited to the embodiments set forth herein. In the drawings, the thickness of layers and regions are exaggerated for clarity. Like numbers refer to like elements throughout. It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Moreover, each embodiment described and illustrated herein includes its complementary conductivity type embodiment as well.

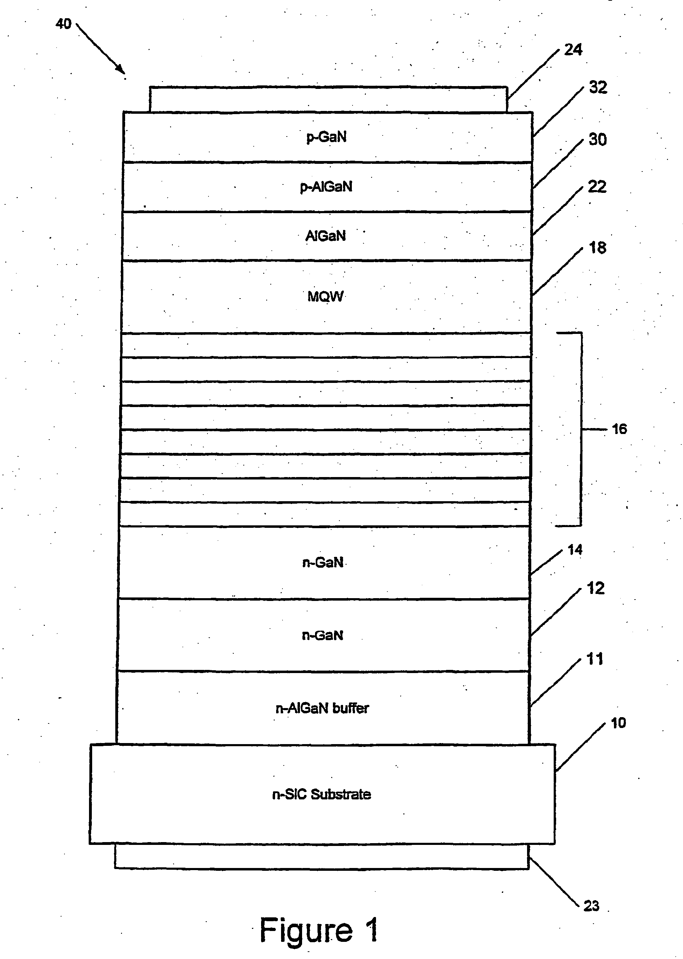

Embodiments of the present invention will be described with reference to **Figure 1** that illustrates a light emitting diode (LED) structure **40.** The LED structure **40** of **Figure 1** includes a substrate **10,** which is preferably 4H or 6H n-type silicon carbide. Substrate **10** may also comprise sapphire, bulk gallium nitride or another suitable substrate. Also included in the LED structure **40** of **Figure 1** is a layered semiconductor structure comprising gallium nitride-based semiconductor layers on substrate **10.** Namely, the LED structure **40** illustrated includes the following layers: a n-type buffer layer **11,** a first silicon-doped GaN layer **12,** a second silicon doped GaN layer **14,** a superlattice structure **16** comprising alternating layers of silicon-doped GaN and InGaN, an active region **18,** which may be provided by a multi-quantum well structure, an undoped GaN and/or AlGaN layer **22,** an AlGaN layer **30** doped with a p-type impurity, and a GaN contact layer **32,** also doped with a p-type impurity. The structure further includes an n-type ohmic contact **23** on the substrate **10** and a p-type ohmic contact **24** on the contact layer **32.**

Buffer layer **11** is preferably n-type AlGaN. Examples of buffer layers between silicon carbide and group III-nitride materials are provided in U.S. Patents 5,393,993 and 5,523,589, and U.S. Application Serial No. 09/154,363 entitled "Vertical Geometry InGaN Light Emitting Diode" assigned to the assignee of the present invention, the disclosures of which are incorporated by reference as if fully set forth herein. Similarly, embodiments of the present invention may also include structures such as those described in United States Patent No. 6,201,262 entitled "Group III Nitride Photonic Devices on Silicon Carbide Substrates With Conductive Buffer Interlay Structure," the disclosure of which is incorporated herein by reference as if set forth fully herein.

GaN layer **12** is preferably between 500 and 4000 nm thick inclusive and is most preferably 1500 nm thick. GaN layer **12** is doped with silicon at a level of 5x10¹⁷ to 5x10¹⁸ cm⁻³. GaN layer **14** is preferably between 1 nm and 50 nm thick inclusive, and is most preferably 8 nm thick. GaN layer **14** is doped with silicon at a level of less than 5x10¹⁹ cm⁻³.

As illustrated **in** **Figure 1****,** a superlattice structure **16** according to embodiments of the present invention includes alternating layers of In_{X}Ga_{1-X}N and In_{Y}Ga_{1-Y}N, wherein X is 0. The thickness of each of the alternating layers of InGaN is 0,5-4 nm thick inclusive, and the thickness of each of the alternating layers of GaN is 0,5-10 nm thick inclusive. In certain embodiments, the GaN layers are 3 nm thick and the InGaN layers are 1,5 nm thick. The superlattice structure **16** may include from 5 to about 50 periods (where one period equals one repetition each of the In_{X}Ga_{1-X}N and In_{Y}Ga_{1-Y}N layers that comprise the superlattice). In one embodiment, the superlattice structure **16** comprises 25 periods. In another embodiment, the superlattice structure **16** comprises **10** periods. The number of periods, however, may be decreased by, for example, increasing the thickness of the respective layers. Thus, for example, doubling the thickness of the layers may be utilized with half the number of periods. Alternatively, the number and thickness of the periods may be independent of one another.

The superlattice **16** is doped with silicon at a level of from 1x10¹⁷ cm⁻³ to 5x10¹⁹ cm⁻³. Such a doping level may be actual doping or average doping of the layers of the superlattice **16.** If such doping level is an average doping level, then it may be beneficial to provide doped layers adjacent the superlattice structure **16** that provide the desired average doping which the doping of the adjacent layers is averaged over the adjacent layers and the superlattice structure **16.** By providing the superlattice **16** between substrate **10** and active region **18,** a better surface may be provided on which to grow InGaN-based active region **18.** While not wishing to be bound by any theory of operation, the inventors believe that strain effects in the superlattice structure **16** provide a growth surface that is conducive to the growth of a high-quality InGaN-containing active region. Further, the superlattice is known to influence the operating voltage of the device. Appropriate choice of superlattice thickness and composition parameters can reduce operating voltage and increase optical efficiency.

The superlattice structure **16** may be grown in an atmosphere of nitrogen or other gas, which enables growth of higher-quality InGaN layers in the structure. By growing a silicon-doped InGaN/GaN superlattice on a silicon-doped GaN layer in a nitrogen atmosphere, a structure having improved crystallinity and conductivity with optimized strain may be realized.

In certain embodiments of the present invention, the active region **18** may comprise a single or multi-quantum well structure as well as single or double heterojunction active regions. In particular embodiments of the present invention, the active region **18** comprises a multi-quantum well structure that includes multiple InGaN quantum well layers separated by barrier layers (not shown in **Figure 1**).

Layer **22** is provided on active region **18** and is preferably undoped GaN or AlGaN between 0 and 12 nm thick inclusive. As used herein, undoped refers to a not intentionally doped. Layer **22** is preferably **3,5** nm thick. If layer **22** comprises AlGaN, the aluminum percentage in such layer is preferably 10-30% and most preferably 24%. The level of aluminum in layer **22** may also be graded in a stepwise or continuously decreasing fashion. Layer **22** may be grown at a higher temperature than the growth temperatures in quantum well region **25** in order to improve the crystal quality of layer **22.** Additional layers of undoped GaN or AlGaN may be included in the vicinity of layer **22.** For example, LED **1** may include an additional layer of undoped AlGaN about 0,6 - 0,9 nm thick between the active region **18** and the layer **22.**

An AlGaN layer **30** doped with a p-type impurity such as magnesium is provided on layer **22.** The AlGaN layer **30** may be between 0 and 30 nm thick inclusive and is preferably 13 nm thick. A contact layer **32** of p-type GaN is provided on the layer **30** and is preferably 180 nm thick. Ohmic contacts **24** and **25** are provided on the p-GaN contact layer **32** and the substrate **10,** respectively.

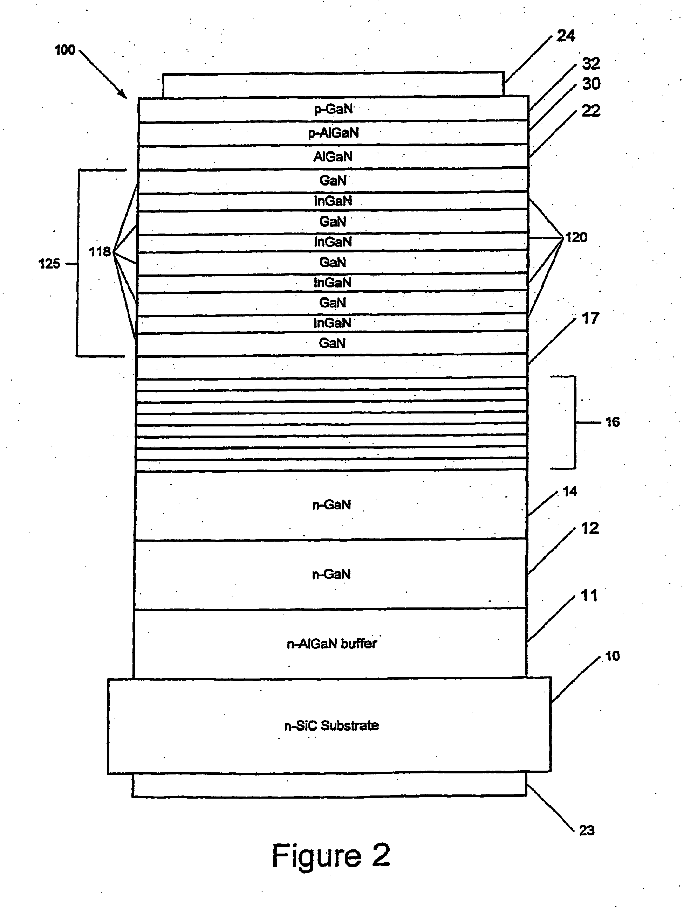

**Figure 2** illustrates further embodiments of the present invention incorporating a multi-quantum well active region. The embodiments of the present invention illustrated in **Figure 2** include a layered semiconductor structure **100** comprising gallium nitride-based semiconductor layers grown on a substrate **10.** As described above, the substrate **10** may be SiC, sapphire or bulk gallium nitride. As is illustrated in **Figure 2****,** LEDs according to particular embodiments of the present invention may include a n-type buffer layer **11,** a first silicon-doped GaN layer **12,** a second silicon doped GaN layer **14,** a superlattice structure **16** comprising alternating layers of silicon-doped GaN and InGaN, an active region **125** comprising a multi-quantum well structure, an undoped GaN or AlGaN layer **22,** an AlGaN layer **30** doped with a p-type impurity, and a GaN contact layer **32,** also doped with a p-type impurity. The LEDs may further include an n-type ohmic contact **23** on the substrate **10** and a p-type ohmic contact **24** on the contact layer **32.** In embodiments of the present invention where the substrate **10** is sapphire, the n-type ohmic contact **23** would be provided on n-type GaN layer **12** and/or n-type GaN layer **14.**

As described above with reference to **Figure 1****,** buffer layer **11** is preferably n-type AlGaN. Similarly, GaN layer **12** is preferably between 500 and 4000 nm thick inclusive and is most preferably 1500 nm thick. GaN layer **12** may be doped with silicon at a level of 5x10¹⁷ to 5x10¹⁸ cm⁻³. GaN layer **14** is preferably between 1 nm and 50 nm thick inclusive, and is most preferably 8 nmthick. GaN layer **14** may be doped with silicon at a level of less than 5x10¹⁹ cm⁻³. The superlattice structure **16** may also be provided as described above with reference to **Figure 1****.**

The active region **125** comprises a multi-quantum well structure that includes multiple InGaN quantum well layers **120** separated by barrier layers **118.** The barrier layers **118** comprise In_{X}Ga_{1-X}N where 0≤X<1. Preferably the indium composition of the barrier layers **118** is less than that of the quantum well layers **120,** so that the barrier layers **118** have a higher bandgap than quantum well layers **120.** The barrier layers **118** and quantum well layers **120** may be undoped (*i*.*e*. not intentionally doped with an impurity atom such as silicon or magnesium). However, it may be desirable to dope the barrier layers **118** with Si at a level of less than 5x10¹⁹ cm⁻³, particularly if ultraviolet emission is desired.

In further embodiments of the present invention, the barrier layers **118** comprise Al_{X}In_{Y}Ga_{1-X-Y}N where 0<X<1, 0≤Y<1 and X+Y≤1. By including aluminum in the crystal of the barrier layers **118,** the barrier layers **118** may be lattice-matched to the quantum well layers **120,** thereby providing improved crystalline quality in the quantum well layers **120,** which increases the luminescent efficiency of the device.

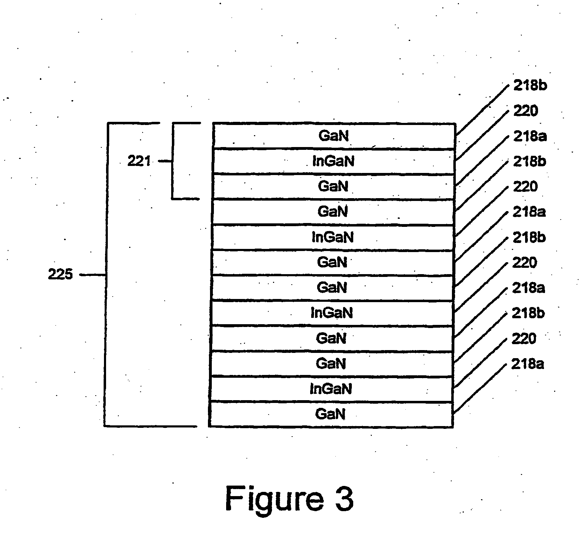

Referring to **Figure 3****,** embodiments of the present invention that provide a multi-quantum well structure of a gallium nitride based device are illustrated. The multi-quantum well structure illustrated in **Figure 3** may provide the active region of the LEDs illustrated in **Figure 1** and/or **Figure 2**. As seen in **Figure 3**, an active region **225** comprises a periodically repeating structure **221** comprising a well support layer **218a** having high crystal quality, a quantum well layer **220** and a cap layer **218b** that serves as a protective cap layer for the quantum well layer **220.** When the structure **221** is grown, the cap layer **218b** and the well support layer **218a** together form the barrier layer between adjacent quantum wells **220.** Preferably, the high quality well support layer **218a** is grown at a higher temperature than that used to grow the InGaN quantum well layer **220.** In some embodiments of the present invention, the Well support layer **218a** is grown at a slower growth rate than the cap layer **218b.** In other embodiments, lower growth rates may be used during the lower temperature growth process and higher growth rates utilized during the higher temperature growth process. For example, in order to achieve a high quality surface for growing the InGaN quantum well layer **220,** the well support layer **218a** may be grown at a growth temperature of between about 700 and 900 °C. Then, the temperature of the growth chamber is lowered by from about 0 to about 200 °C to permit growth of the high-quality InGaN quantum well layer **220.** Then, while the temperature is kept at the lower InGaN growth temperature, the cap layer **218b** is grown. In that manner, a multi-quantum well region comprising high quality InGaN layers may be fabricated.

The active regions **125** and **225** of **Figures 2** and **3** are preferably grown in a nitrogen atmosphere, which may provide increased InGaN crystal quality. The barrier layers **118,** the well support layers **218a** and/or the cap layers **218b** may be between 5 nm - 40 nm thick inclusive. The combined thickness of corresponding ones of the well support layers **218a** and the cap layers **218b** may be from 5 nm-40 nm thick inclusive. Preferably, the barrier layers **118** the well support layers **218a** and/or the cap layers **218b** are greater than about 9 nm thick and most preferably are 22,5 nm thick. Also, it is preferred that the well support layers **218a** be thicker than the cap layers **218b.** Thus, the cap layers **218b** are preferably as thin as possible while still reducing the desorption of Indium from or the degradation of the quantum well layers **220.** The quantum well layers **120** and **220** may be between 1 nm - 5 nm thick inclusive. Preferably, the quantum well layers **120** and **220** are greater than 2 nm thick and most preferably are 2,5 nm thick. The thickness and percentage of indium in the quantum well layers **120** and **220** may be varied to produce light having a desired wavelength. Typically, the percentage of indium in quantum well layers **120** and **220** is 25-30%, however, depending on the desired wavelength, the percentage of indium has been varied from 5% to 50%.

In preferred embodiments of the present invention, the bandgap of the superlattice structure **16** exceeds the bandgap of the quantum well layers **120.** This may be achieved by by adjusting the average percentage of indium in the superlattice **16.** The thickness (or period) of the superlattice layers and the average Indium percentage of the layers should be chosen such that the bandgap of the superlattice structure **16** is greater than the bandgap of the quantum wells **120.** By keeping the bandgap of the superlattice **16** higher than the bandgap of the quantum wells **120,** unwanted absoxption in the device may be minimized and luminescent emission may be maximized. The bandgap of the superlattice structure **16** may be from 2.95 eV to 3.35 eV. In a preferred embodiment, the bandgap of the superlattice structure **16** is 3.15 eV.

In additional embodiments of the present invention, the LED structure illustrated in **Figure 2** includes a spacer layer **17** disposed between the superlattice **16** and the active region **125.** The spacer layer **17** preferably comprises undoped GaN. The presence of the optional spacer layer **17** between the doped superlattice **16** and active region **125** may deter silicon impurities from becoming incorporated into the active region **125.** This, in turn, may improve the material quality of the active region **125** that provides more consistent device performance and better uniformity. Similarly, a spacer layer may also be provided in the LED structure illustrated in **Figure 1** between the superlattice **16** and the active region **18.**

Returning to **Figure 2****,** the layer **22** provided on the active region **125** is preferably undoped GaN or AlGaN between 0 and 12 nm thick inclusive. The layer **22** is preferably 3,5 nm thick. If the layer **22** comprises AlGaN, the aluminum percentage in such layer is preferably 10-30% and most preferably 24%. The level of aluminum in the layer **22** may also be graded in a stepwise or continuously decreasing fashion. The layer **22** may be grown at a higher temperature than the growth temperatures in the active region **125** in order to improve the crystal quality of the layer **22.** Additional layers of undoped GaN or AlGaN may be included in the vicinity of layer **22.** For example, the LED illustrated in **Figure 2** may include an additional layer of undoped AlGaN 0.6 to 0.9 nm thick between the active regions **125** and the layer **22.**

An AlGaN layer **30** doped with a p-type impurity such as magnesium is provided on layer **22.** The AlGaN layer **30** may be between 0 and 30 nm thick inclusive and is preferably 13 nm thick. A contact layer **32** of p-type GaN is provided on the layer **30** and is preferably 180 nmthick. Ohmic contacts **24** and **25** are provided on the p-GaN contact layer **32** and the substrate **10,** respectively. Ohmic contacts **24** and **25** are provided on the p-GaN contact layer **32** and the substrate **10,** respectively.

While embodiments of the present invention have been described with multiple quantum wells, the benefits from the teachings of the present invention may also be achieved in single quantum well structures. Thus, for example, a light emitting diode may be provided with a single occurrence of the structure **221** of **Figure 3** as the active region of the device. Thus, while different numbers of quantum wells may be utilized according to embodiments of the present invention, the number of quantum wells will typically range from 1 to 10 quantum wells.

While embodiments of the present invention have been described with reference to gallium nitride based devices, the teachings and benefits of the present invention may also be provided in other Group III nitrides. Thus, embodiments of the present invention provide Group III nitride based superlattice structures, quantum well structures and/or Group III nitride based light emitting diodes having superlattices and/or quantum wells.

## Claims

1. A Group III nitride based light-emitting diode, comprising:
a substrate (10);
an n-type buffer layer (11);
a first GaN layer (12);
a second GaN layer (14);
an InGaN based superlattice structure (16) having at least two periods of alternating layers of GaN and In_{y}Ga_{1-y}N, where 0 < Y < 1, wherein the GaN layers of the alternating layers have a thickness of 0.5 nm to 10 nm and the InGaN layers of the alternating layers have a thickness of 0.5 nm to 4 nm;
an InGaN based light emitting region (18, 125, 225) formed on the superlattice structure (16);
an undoped GaN or AlGaN layer (22) formed on the light emitting region;
a p-type AlGaN layer (30); and
a p-type GaN contact layer (32),
**characterised by**
the first and second GaN layers (12,14) being Si-doped;
the superlattice structure (16) being formed directly on the second GaN layer (14); and
the alternating layers of GaN and InGaN of the superlattice structure (16) being Si-doped to an average level of 1x10¹⁷ cm⁻³ to 5x10¹⁹ cm⁻³.

2. A Group III nitride based light-emitting diode according to claim 1, wherein the GaN layers of said alternating layers have a thickness of 3 nm and the InGaN layers of said alternating layers have a thickness of 1.5 nm.

3. A Group III nitride based light-emitting diode according to any preceding claim, wherein the superlattice structure (16) comprises from 5 to 50 periods.

4. A Group III nitride based light-emitting diode according to claim 3, wherein the superlattice structure (16) comprises 25 periods.

5. A Group III nitride based light-emitting diode according to any preceding claim, wherein the layers of GaN and InGaN of said alternating layers in each period have a combined thickness of less than 7 nm.

6. A Group III nitride based light-emitting diode according to any preceding claim, wherein the doping level of each layer of the superlattice structure (16) is within the defined range.

7. A Group III nitride based light-emitting diode according to any preceding claim, wherein the superlattice structure (16) has a bandgap from 2.95 eV to 3.15 eV.

8. A Group III nitride based light-emitting diode according to claim 7, wherein the superlattice structure (16) has a bandgap of 3.15 eV.

9. A Group III nitride based light-emitting diode according to any preceding claim, further comprising a Group III nitride based spacer layer (17) between the light emitting region (18,125,225) and the superlattice structure (16).

10. A Group III nitride based light-emitting diode according to claim 9, wherein the spacer layer (17) comprises undoped GaN.

11. A Group III nitride based light-emitting diode according to claim 9 or claim 10, wherein the light emitting region (18,125,225) comprises at least one quantum well (221).

12. A Group III nitride based light-emitting diode according to claim 11, wherein said quantum well (221) has a bandgap less than that of the superlattice structure (16).

## Patentansprüche

1. Auf einem Gruppe III-Nitrid basierende Leuchtdiode, die aufweist:
ein Substrat (10),
eine Pufferschicht (11) des n-Typs,
eine erste GaN-Schicht (12),
eine zweite GaN-Schicht (14),
eine auf InGaN basierende Übergitterstruktur (16) mit wenigstens zwei Perioden von abwechselnden Schichten aus GaN und In_{y}Ga_{1-y}N, wobei 0 < y < 1 ist, wobei die Gas-Schichten der abwechselnden Schichten eine Dicke von 0,5 nm bis 10 nm haben und die InGaN-Schichten der abwechselnden Schichten eine Dicke von 0,5 nm bis 4 nm haben,
einen auf InGaN basierenden lichtemittierenden Bereich (18, 125, 225), der auf der Übergitterstruktur (16) ausgebildet ist,
eine undotierte GaN- oder AlGaN-Schicht (22), die auf dem lichtemittlerenden Bereich ausgebildet ist,
eine AlGaN-Schicht (30) des p-Typs und
eine GaN-Kontaktschicht (32) des p-Typs,
**dadurch gekennzeichnet, daß**
die ersten und die zweiten GaN-Schichten (12, 14) Si-dotiert sind,
die Übergltterstruktur (16) direkt auf der zweiten GaN-Schicht (14) ausgebildet ist und
die abwechselnden Schichten aus GaN und InGaN der Übergitterstruktur (16) bis zu einem mittleren Niveau von 1 x 10¹⁷ cm⁻³ bis 5 x 10¹⁹ cm⁻³ Si-diotiert sind.

2. Auf einem Gruppe III-Nitrid basierende Leuchtdiode nach Anspruch 1, wobei die GaN-Schichten der abwechselnden Schichten eine Dicke von 3 nm haben und die InGaN-Schichten der abwechselnden Schichten eine Dicke von 1,5 nm haben.

3. Auf einem Gruppe III-Nitrid basierende Leuchtdiode nach einem der vorangegangenen Ansprüche, wobei die Übergitterstruktur (16) 5 bis 50 Perioden beinhaltet.

4. Auf einem Gruppe III-Nitrid basierende Leuchtdiode nach Anspruch 3, wobei die Übergitterstruktur (16) 25 Perioden beinhaltet.

5. Auf einem Gruppe III-Nitrid basierende Leuchtdiode nach einem der vorangegangenen Ansprüche, wobei die Schichten aus GaN und InGaN der abwechselnden Schichten in jeder Periode eine kombinierte Dicke von weniger als 7 nm haben.

6. Auf einem Gruppe III-Nitrid basierende Leuchtdiode nach einem der vorangegangenen Ansprüche, wobei das Dotiemiveau jeder Schicht der Übergitterstruktur (16) innerhalb des definierten Bereichs liegt.

7. Auf einem Gruppe III-Nitrid basierende Leuchtdiode nach einem der vorangegangenen Ansprüche, wobei die Übergitterstruktur (16) eine Bandlücke von 2,95 eV bis 3,15 eV hat.

8. Auf einem Gruppe III-Nitrid basierende Leuchtdiode nach Anspruch 7, wobei die Übergitterstruktur (16) eine Bandlücke von 3,15 eV hat.

9. Auf einem Gruppe III-Nitrid basierende Leuchtdiode nach einem der vorangegangenen Ansprüche, welche weiterhin eine auf einem Gruppe III-Nitrid basierende Abstandsschicht (17) zwischen dem lichtemittierenden Bereich (18, 125, 225) und der Übergitterstruktur (16) aufweist.

10. Auf einem Gruppe III-Nitrid basierende Leuchtdiode nach Anspruch 9, wobei die Abstandsschicht (17) undotiertes GaN beinhaltet.

11. Auf einem Gruppe III-Nitrid basierende Leuchtdiode nach Anspruch 9 oder Anspruch 10, wobei der lichtemittierende Bereich (18, 125, 225) wenigstens einen Quantentopf (221) aufweist.

12. Auf einem Gruppe III-Nitrid basierende Leuchtdiode nach Anspruch 11, wobei der Quantentopf (221) eine Bandlücke hat, die kleiner ist als die der Übergitterstruktur (16).

## Revendications

1. Diode électroluminescente à base de nitrure du groupe III, comprenant :
un substrat (10) ;
une couche tampon de type n (11) ;
une première couche de GaN (12) ;
une deuxième couche de GaN (14) ;
une structure de super réseau à base d'InGaN (16) ayant au moins deux périodes de couches alternées de GaN et d'InyGa_{1-y}N, où 0 < Y < 1, dans laquelle les couches de GaN des couches alternées ont une épaisseur de 0,5 nm à 10 nm et les couches d'InGaN des couches alternées ont une épaisseur de 0,5 nm à 4 nm ;
une région d'émission de lumière à base d'InGaN (18, 125, 225) formée sur la structure de super réseau (16) ;
une couche de GaN ou d'AlGaN non dopée (22) formée sur la région d'émission de lumière ;
une couche d'AlGaN de type p (30) ; et
une couche de contact de GaN de type p (32),
**caractérisée en ce que**
les première et deuxième couches de GaN (12, 14) sont dopées au Si ;
la structure de super réseau (16) est formée directement sur la deuxième couche de GaN (14) ; et
les couches alternées de GaN et d'InGaN de la structure de super réseau (16) sont dopées au Si à un niveau moyen de 1 x 10¹⁷ cm⁻³ à 5 x 10¹⁹ cm⁻³.

2. Diode électroluminescente à base de nitrure du groupe III selon la revendication 1, dans laquelle les couches de GaN desdites couches alternées ont une épaisseur de 3 nm, et les couches d'InGaN desdites couches alternées ont une épaisseur de 1,5 nm.

3. Diode électroluminescente à base de nitrure du groupe III selon l'une quelconque des revendications précédentes, dans laquelle la structure de super réseau (16) comprend de 5 à 50 périodes.

4. Diode électroluminescente à base de nitrure du groupe III selon la revendication 3, dans laquelle la structure de super réseau (16) comprend 25 périodes.

5. Diode électroluminescente à base de nitrure du groupe III selon l'une quelconque des revendications précédentes, dans laquelle les couches de GaN et d'InGaN desdites couches alternées dans chaque période ont une épaisseur combinée inférieure à 7 nm.

6. Diode électroluminescente à base de nitrure du groupe III selon l'une quelconque des revendications précédentes, dans laquelle le niveau de dopage de chaque couche de la structure de super réseau (16) est dans la plage définie.

7. Diode électroluminescente à base de nitrure du groupe III selon l'une quelconque des revendications précédentes, dans laquelle la structure de super réseau (16) a une largeur de bande de 2,95 eV à 3,15 eV.

8. Diode électroluminescente à base de nitrure du groupe III selon la revendication 7, dans laquelle la structure de super réseau (16) a une largeur de bande de 3,15 eV.

9. Diode électroluminescente à base de nitrure du groupe III selon l'une quelconque des revendications précédentes, comprenant en outre une couche d'espacement à base de nitrure du groupe III (17) entre la région d'émission de lumière (18, 125, 225) et la structure de super réseau (16).

10. Diode électroluminescente à base de nitrure du groupe III selon la revendication 9, dans laquelle la couche d'espacement (17) comprend du GaN non dopé.

11. Diode électroluminescente à base de nitrure du groupe III selon la revendication 9 ou la revendication 10, dans laquelle la région d'émission de lumière (18, 125, 225) comprend au moins un puits quantique (221).

12. Diode électroluminescente à base de nitrure du groupe III selon la revendication 11, dans laquelle ledit puits quantique (221) a une largeur de bande inférieure à celle de la structure de super réseau (16).
